# EUROPÄISCHE PATENTSCHRIFT

(11) **EP 3 380 852 B1**
(45) Veröffentlichungstag und Bekanntmachung des Hinweises auf die Patenterteilung: **29.12.2021**
(21) Anmeldenummer: 16801436.3
(22) Anmeldetag: 23.11.2016
(51) Int. Cl.: G01R 15/18, G01R 22/06

(54) **INDUKTIVER STROMMESSWANDLER**
INDUCTIVE CURRENT TRANSFORMER
TRANSFORMATEUR DE MESURE DE COURANT INDUCTIF

(30) Priorität: 24.11.2015 DE 102015120319
(43) Veröffentlichungstag der Anmeldung: 03.10.2018
(73) Patentinhaber: Phoenix Contact GmbH & Co. KG, 32825 Blomberg (DE)
(72) Erfinder: JANKOWSKI, Martin, 30926 Seelze (DE)
(74) Vertreter: Blumbach · Zinngrebe Patentanwälte PartG mbB
(86) Internationale Anmeldenummer: PCT/EP2016/078568
(87) Internationale Veröffentlichungsnummer: WO 2017/089407

(56) Entgegenhaltungen:
- EP-A2- 2 369 353
- DD-A1- 251 850
- DE-T5-112010 001 638

## Beschreibung

Die Erfindung betrifft einen induktiven Strommesswandler zum Transformieren eines zum messenden elektrischen Primärstroms in einen elektrischen Sekundärstrom sowie eine Messanordnung, welche einen solchen induktiven Strommesswandler umfasst.

Bekannt ist zum Beispiel, in der Prozessautomation hohe Ströme von beispielsweise 200 A mit Hilfe von Strommesswandlern zu überwachen.

Aus der DE 36 15 463 A1 ist eine Anordnung zur Signalübertragung in einer Messanordnung bekannt, die einen Messumformer und ein entfernt davon angeordnetes Auswertegerät enthält. Der Messumformer ist mit dem Auswertegerät durch eine Zweidrahtleitung verbunden, über die einerseits die für den Betrieb des Messumformers erforderliche Gleichspannung vom Auswertegerät zum Messumformer und andererseits das die Messgröße darstellende Messwertsignal vom Messumformer zum Auswertegerät übertragen werden.

Aus der DE 29 521 924 A1 ist eine Vorrichtung zum Erzeugen und Verarbeiten von Messsignalen bekannt, welche einen Sensor mit einem Messwandler und eine vom Sensor entfernte Auswerteeinheit zum Auswerten des Messsignals des Sensors aufweist. Der Sensor kann über eine Datenübertragungsleitung mit der Auswerteeinheit verbunden weren, über die unter anderem Kenndaten des Sensors übertragen werden können. EP 2 369 353 beschreibt eine kontaktlose Strommessvorrichtung mit einer internen Energieversorgungseinrichtung, mit der eine elektronische Einrichtung, nämlich eine Auswerteeinrichtung und eine Kommunikationseinrichtung mit Energie versorgt werden kann.

Der vorliegenden Erfindung liegt die Aufgabe zugrunde, einen induktiven Strommesswandler zu schaffen, dessen interne Elektronik unabhängig von einem externen Gerät mit Energie versorgt werden kann.

Ein Kerngedanke der Erfindung kann darin gesehen werden, dass ein induktiver Strommesswandler eine integrierte Elektronik selbst aus seinem Sekundärstromkreis mit Energie versorgt und Daten über die an die Sekundärwicklung angeschlossenen Sekundärstromleitungen mittels Strommodulation übertragen kann.

Das oben genannte Problem wird zum einen durch die Merkmale des Anspruchs 1 gelöst.

Danach ist ein induktiver Strommesswandler zum Transformieren eines zu messenden elektrischen Primärstroms in einen elektrischen Sekundärstrom vorgesehen. Bei dem induktiven Strommesswandler kann es sich beispielsweise um einen Durchsteckstrommesswandler handeln. Der induktive Strommesswandler weist eine Sekundärwicklung mit zwei Anschlüssen auf. Ferner ist im induktiven Strommesswandler eine elektronische Einrichtung integriert, die zum Übertragen von Informationen zu einem externen Messgerät ausgebildet ist, welches über eine Anschlussleitung mit dem induktiven Strommesswandler verbindbar ist.

Die Informationen können Kenndaten des induktiven Strommesswandlers enthalten, die in einem Speicher der elektronischen Einrichtung gespeichert werden können.

Ferner weist der induktive Strommesswandler eine induktive Ankopplungseinrichtung auf, die mit der Sekundärwicklung verbunden ist. Eine interne Energieversorgungseinrichtung ist über die Ankopplungseinrichtung mit der Sekundärwicklung gekoppelt und dazu ausgebildet, aus dem elektrischen Sekundärstrom der Sekundärwicklung eine Versorgungsspannung für die elektronische Einrichtung zu erzeugen.

Zudem weist der induktive Strommesswandler zwei Anschlussleiter auf, die jeweils mit einem der Anschlüsse der Sekundärwicklung und jeweils mit einem Ausgangsanschluss verbunden sind. An die Ausgangsanschlüsse ist die Anschlussleitung anschließbar. Die Ankopplungseinrichtung ist vorzugsweise als Stromwandler mit einer ersten und einer zweiten Wicklung ausgebildet, wobei einer der Anschlussleiter die erste Wicklung des Stromwandlers bildet und die zweite Wicklung mit der internen Energieversorgungseinrichtung verbunden ist.

Zweckmäßigerweise ist die elektronische Einrichtung dazu ausgebildet, den Sekundärstrom der Sekundärwicklung gezielt zu modulieren, um Informationen, vorzugsweise Kenndaten zum externen Messgerät übertragen zu können.

Um einen sicheren Betrieb zu ermöglichen, sollte die Trägerfrequenz des die Informationen enthaltenen Signals deutlich höher als die Oberwellen des zu messenden elektrischen Primärstroms sein, damit der Sekundärstrom, der das eigentliche Messsignal repräsentiert, nicht durch das modulierte Signal verfälscht wird.

Um Informationen über den Sekundärstrom übertragen zu können, kann die elektronische Einrichtung zweckmäßiger Weise über die erste induktive Ankopplungseinrichtung, oder eine zweite induktive Ankopplungseinrichtung oder eine kapazitive Ankopplungseinrichtung an die Sekundärwicklung angekoppelt sein, um den Sekundärstrom gezielt modulieren zu können.

Eine vorteilhafte Weiterbildung sieht vor, dass die elektronische Einrichtung des induktiven Strommesswandlers eine Messeinrichtung zum Messen des Sekundärstroms, eine Messeinrichtung zum Messen einer an den Anschlüssen der Sekundärwicklung anliegenden Sekundärspannung und einer Einrichtung zum Berechnen der elektrischen Leistung in Abhängigkeit vom Sekundärstrom und von der Sekundärspannung aufweist.

Hierbei kann die elektronische Einrichtung dazu ausgebildet sein, unter Ansprechen auf eine berechnete elektrische Leistung das Überschreiten einer definierten Bemessungsleistung zu erkennen und diesen Zustand mittels einer Modulation des Sekundärstroms einem externen Messgerät zu signalisieren. Zu diesem Zweck kann die elektronische Einrichtung einen Mikrokontroller als Steuereinheit umfassen.

Um den induktiven Strommesswandler noch intelligenter zu machen, kann die elektronische Einrichtung einen Temperatursensor aufweisen wobei die elektronische Einrichtung dazu ausgebildet sein kann, mittels einer Modulation des Sekundärstroms vom Temperatursensor ermittelte Temperaturwerte zum externen Messgerät zu übertragen.

Das oben genannte technische Problem wird ebenfalls durch die Merkmale des Anspruchs 9 gelöst.

Danach ist eine Messanordnung vorgesehen, welche einen induktiven Strommesswandler nach einem der vorstehenden Ansprüche und ein externes Messgerät aufweist, welches über eine Anschlussleitung mit dem induktiven Strommesswandler verbunden ist.

Um den vom induktiven Strommesswandler modulierten Sekundärstrom demodulieren und auswerten zu können, weist das externe Messgerät entsprechende Einrichtungen zum Demodulieren und Auswerten auf.

Die Erfindung wird nachfolgend anhand einiger Ausführungsbeispiele in Verbindung mit den beiliegenden Zeichnungen näher erläutert. Es zeigen:
Fig. 1 eine schematische Vorderansicht eines erfindungsgemäßen induktiven Strommesswandlers, bei dem die vordere Gehäusewand entfernt ist,
Fig. 2 eine beispielhafte Ausgestaltung der in Fig. 1 gezeigten induktiven Ankopplungseinrichtung,
Fig. 3 eine induktive Ankopplungseinrichtung zur Modulation des Sekundärstroms,
Fig. 4 eine kapazitive Ankopplungseinrichtung zur Modulation des Sekundärstroms und
Fig. 5 eine beispielhafte Messanordnung mit dem in Fig. 1 gezeigten induktiven Strommesswandler.

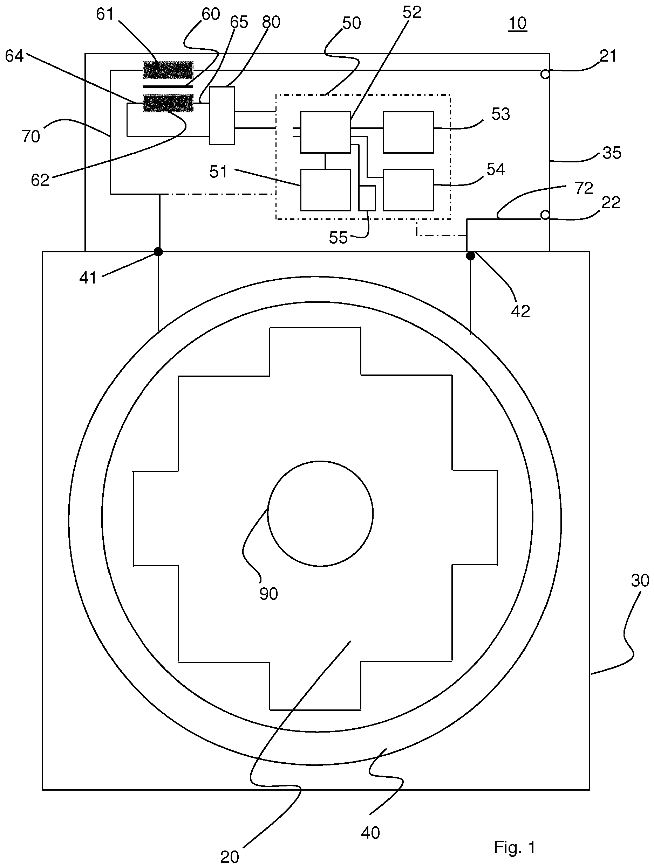

In Figur 1 ist ein Blockschaltbild eines beispielhafter induktiver Strommesswandler 10 dargestellt, der Beispiel als Durchsteckstromwandler ausgebildet ist.

Der induktive Strommesswandler 10 dient unter anderem zum Transformieren eines zu messenden elektrischen Primärstroms, der durch einen Leiter 90 fließen kann, in einen elektrischen Sekundärstrom. Bei dem beispielhaft dargestellten Durchsteckstromwandler 10 bildet der den zu messenden elektrischen Primärstrom führende Leiter 90 die Primärwicklung des induktiven Stromwandlers 10. Dieser Stromleiter 90 ist durch eine Durchstecköffnung 20 des induktiven Strommesswandlers 10 hindurchgeführt, wie dies in Fig. 1 angedeutet ist. Der induktive Strommesswandler 10 weist in an sich bekannter Weise eine Sekundärwicklung 20 mit zwei Anschlüssen 41 und 42 auf. Die Sekundärwicklung 40 kann in einem Gehäuse 30 angeordnet sein. Der induktive Strommesswandler 10 weist weiterhin eine elektronische Einrichtung 50 beziehungsweise eine elektronische Funktionsbaugruppe auf, die unter anderem zum Übertragen von Informationen zu einem externen Messgerät 120 ausgebildet ist. Als Informationen können vorzugsweise Kenndaten, wie zum Beispiel der Primärnennstrom und der Sekundärnennstrom, welche für das Übertragungsverhältnis des induktiven Strommesswandlers 10 maßgeblich sind, Abgleichparameter, die Seriennummer für die Identifizierung des induktiven Strommesswandlers 10 übertragen werden. Die Kenndaten könne in einem Speicher 55 abgelegt werden.

Die elektronische Einrichtung 50 kann in einem Kopfteil des induktiven Strommesswandlers 10 untergebracht sein, der in einem separaten Gehäuse 35 angeordnet sein kann. Das Kopfteil kann als steckbares Modul ausgebildet sein, um lösbar an dem Gehäuse 30 befestigt werden zu können. Alternativ kann das Gehäuse 35 des Kopfteils auch während der Montage mit dem Gehäuse 30 verklebt oder in einer anderen Art und Weise in einer nicht mehr lösbaren Weise verbunden werden.

Der induktive Strommesswandler 10 weist eine erste mit der Sekundärwicklung 40 verbundene induktive Ankopplungseinrichtung 60 auf. Ferner weist der induktive Strommesswandler 10 eine Energieversorgungseinrichtung 80 auf, die über die erste induktive Ankopplungseinrichtung 60 mit der Sekundärwicklung 40 gekoppelt und dazu ausgebildet ist, aus dem elektrischen Sekundärstrom der Sekundärwicklung 40 eine Versorgungsspannung für die elektronische Einrichtung 50 zu erzeugen.

Bei dem gezeigten Beispiel sind die Anschlüsse 41 und 42 der Sekundärwicklung 40 mit einem internen Anschlussleiter 70 bzw. internen Anschlussleiter 72 verbunden. Die elektrische Verbindung zwischen den Anschlüssen 41 und 42 und den Anschlussleitern 70 und 72 erfolgt beim Zusammensetzen des Gehäuses 35 und des Gehäuses 30. Der Anschlussleiter 72 ist mit einem Ausgangsanschluss beziehungsweise einer Ausgangsklemme 22 des induktiven Strommesswandlers 10 verbunden.

In vorteilhafter Weise ist die erste induktive Ankopplungseinrichtung 60 als Stromwandler mit einer ersten Wicklung 61 und einer zweiten Wicklung 62 ausgebildet, wobei einer der beiden Anschlussleiter, im vorliegenden Beispiel der Anschlussleiter 70 die erste Wicklung der Ankopplungseinrichtung 60 bildet und die zweite Wicklung 62 über Anschlüsse 64 und 65 mit der internen Energieversorgungseinrichtung 80 verbunden ist.

Angemerkt sei, dass die in Fig. 1 dargestellte erste induktive Ankopplungseinrichtung 60 in Reihe mit der Sekundärwicklung 40 geschaltet ist, da der Anschlussleiter 70 die erste Wicklung 61 der als Stromwandler ausgebildeten Ankopplungseinrichtung 60 bildet. Eine solche Verschaltung ist vorteilhaft, da der Sekundärstrom der Sekundärwicklung 40, welcher ja dem zu messenden elektrischen Primärstrom entspricht, nicht verfälscht werden darf. Bei dieser Realisierung durchströmt der Sekundärstrom der Sekundärwicklung 40 die induktive Ankopplungseinrichtung 60, die an den Anschlüssen 64 und 65 der zweiten Wicklung 62 eine Spannung liefert, die von der Energieversorgungseinrichtung 80 in eine Gleichspannung zum Speisen der elektronischen Einrichtung 50 bzw. deren Komponenten umgewandelt wird. Beispielsweise wird die an den Anschlüssen 64 und 65 bereitgestellte Spannung der zweiten Wicklung 62 von der Energieversorgungseinrichtung 80 in eine Gleichspannung von etwa 3,3 V umgewandelt. Der Anschlussleiter 70 ist mit einem Anschluss bzw. einer Anschlussklemme 21 des induktiven Strommesswandlers 10 verbunden.

Durch das Abgreifen der Energie im Anschlussleiter 70 wird ein Teil der durch den induktiven Strommesswandler 10 bereitgestellten Scheinleistung genutzt; der Sekundärstrom der Sekundärwicklung 40, der das Messsignal repräsentiert, wird daher im Wesentlichen nicht verändert. Anzumerken ist, dass eine Energieversorgung auf diese Art und Weise nur erfolgt, wenn ein Primärstrom durch den Leiter 90, das heißt durch die Primärwicklung des induktiven Strommesswandlers 10 fließt, der hinreichend groß ist, die elektronische Einrichtung 50 mit Energie zu versorgen. Eine solche Einschränkung kann grundsätzlich hingenommen werden, da die Übertragung der Informationen, vorzugsweise der Kenndaten des induktiven Strommesswandlers nicht zeitkritisch ist, und da weitere Daten, wie zum Beispiel Mess- oder Temperaturdaten nur im Betrieb auftreten.

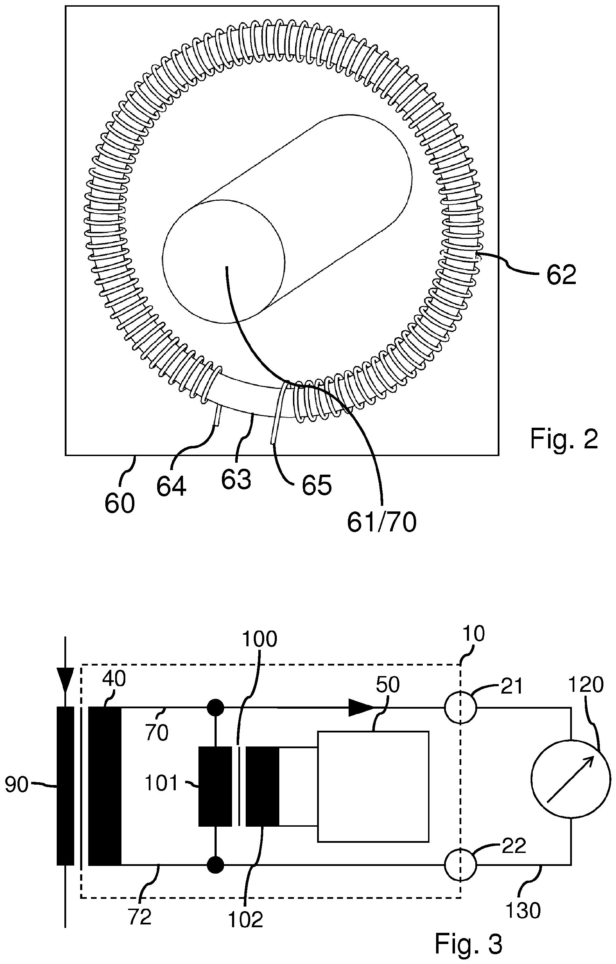

Die beispielhaft als Stromwandler ausgebildete erste induktive Ankopplungseinrichtung 60 ist in Fig. 2 näher dargestellt. Fig. 2 zeigt die erste Wicklung 61 der Ankopplungseinrichtung 60, die durch den Anschlussleiter 70 gebildet wird. Die zweite Wicklung 62 wird vorzugsweise durch eine Toroidspule gebildet, die einen um einen ringförmigen Träger 63 oder einen Ringkern gewickelten Draht besteht. Fig. 2 zeigt ferner die beiden Anschlüsse 64 und 65 der zweiten Wicklung 62.

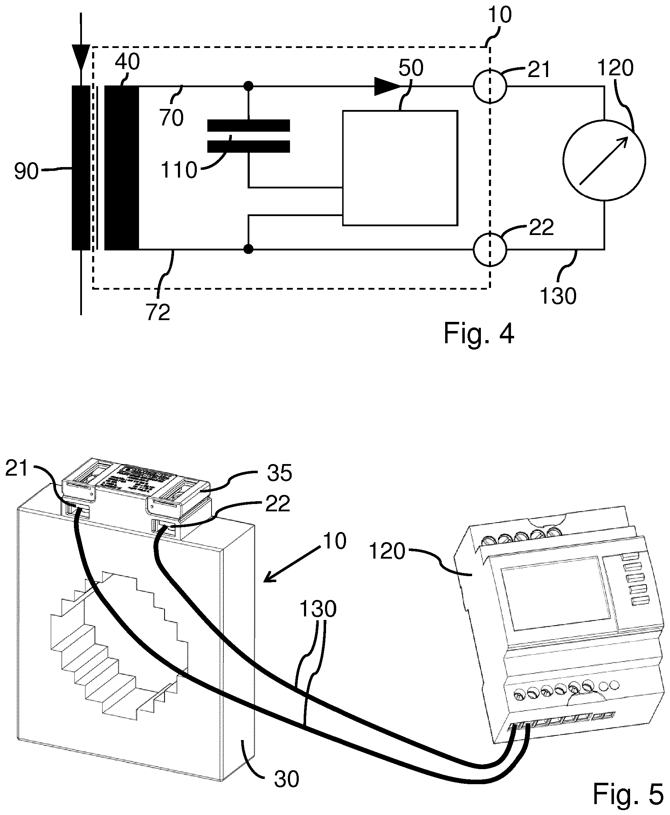

Um Informationen, wie zum Beispiel die im Speicher 55 abgelegten Kenndaten, übertragen zu können, kann die elektronische Einrichtung 50 dazu ausgebildet sein, den Sekundärstrom der Sekundärwicklung 40 gezielt zu modulieren. Die elektronische Einrichtung 50 kann hierzu einen Sender 52 aufweisen, der beispielsweise als Mikrokontroller ausgebildet ist. Der Mikrokontroller 52 kann unter anderem auf den Speicher 55 zugreifen, indem die zum Beispiel die Kenndaten des induktiven Strommesswandlers 10 abgelegt sind. Der Mikrokontroller 52 kann ferner dazu ausgebildet sein, die im Speicher 55 hinterlegten Kenndaten zyklisch dem im Anschlussleiter 70 fließenden Sekundärstrom aufzumodulieren, sobald eine Betriebsspannung über die Energieversorgungseinrichtung 80 bereitgestellt wird. Als Kommunikationsprotokoll kann beispielsweise eine digitale serielle Schnittstelle, wie zum Beispiel die UART (Universal Asynchronous Receiver Transmitter)-Schnittstelle verwendet werden. Die elektronische Einrichtung 50 kann ferner einen Temperatursensor 51 aufweisen, der die Umgebungstemperatur beziehungsweise die Temperatur des induktiven Strommesswandlers 10 überwachen kann. Die vom Temperatursensor 51 ermittelten Temperaturmesswerte können ebenfalls von der elektronischen Einrichtung 50, insbesondere vom Mikrokontroller 52 mittels einer Modulation des Sekundärstroms zu einem in Fig. 5 gezeigten externen Messgerät 120 übertragen werden.

Die elektronische Einrichtung 50 kann ferner eine Messeinrichtung 53 zum Messen einer an den Anschlüssen 41 und 42 der Sekundärwicklung 40 anliegenden Sekundärspannung, eine Messeinrichtung zum Messen des Sekundärstroms sowie eine Einrichtung zum Berechnen der Leistung in Abhängigkeit vom Sekundärstrom und von der Sekundärspannung aufweisen. Das Berechnen der elektrischen Leistung in Abhängigkeit vom Sekundärstrom und von der Sekundärspannung kann im Mikrokontroller 52 ausgeführt werden.

Die elektronische Einrichtung 50, insbesondere der Mikrokontroller 52 können dazu ausgebildet sein, unter Ansprechen auf eine berechnete Leistung das Überschreiten einer vorgegebenen, dem Mikrocontroller 52 bekannten Bemessungsleistung zu erkennen und diesen Zustand mittels einer Modulation des Sekundärstroms einem externen Messgerät 120 zu signalisieren. Es ist sinnvoll, das Überschreitens der vorgegebenen Bemessungsleistung dem externen Messgerät 120 mitzuteilen, da in diesem Fall das Messsignal verfälscht und das Messergebnis falsch ermittelt wird.

Nachfolgend werden einige Ausführungsbeispiele zur Modulation des Sekundärstroms der Sekundärwicklung 40 beschrieben.

Eine Möglichkeit besteht darin, dass die elektronische Einrichtung 50 und insbesondere der Mikrokontroller 52 separate Anschlüsse zum Anschließen an die Anschlüsse 64 und 65 der zweiten Wicklung 62 der induktiven Ankopplungseinrichtung 60 aufweisen. Die separaten Anschlüsse sowie die Anschlüsse zum Anschließen des Mikrocontrollers an die Energieversorgungseinrichtung 80 werden in Fig. 1 symbolisch durch zwei Striche repräsentiert. Sobald die elektronische Einrichtung 50 Daten zu einem externen Messgerät 120 übertragen möchte, treibt der Mikrocontroller 52 einen Signalstrom durch die zweite Wicklung 62, wodurch der Sekundärstrom im Anschlussleiter 70 entsprechend den zu übertragenen Daten moduliert wird.

In Fig. 3 ist eine alternative Modulationseinrichtung des induktiven Strommesswandlers 10 dargestellt. Wie in Fig. 3 gezeigt, ist die elektronische Einrichtung 50 über eine zweite induktive Ankopplungseinrichtung 100, die parallel zur Sekundärwicklung 40 geschaltet ist, an die Sekundärwicklung 40 angekoppelt, um den Sekundärstrom gezielt modulieren zu können. Die zweite induktive Ankopplungseinrichtung 100 weist eine erste Wicklung 101 auf, die parallel zur Sekundärwicklung 40 geschaltet ist. Ferner weist sie eine zweite Wicklung 102 auf, die an die elektronische Einrichtung 50 beziehungsweise den Mikrokontroller 52 geschaltet ist. Weiterhin zeigt Fig. 3 schematisch den Leiter 90 beziehungsweise die Primärwicklung 90, durch die der zu messende Primärstrom fließt. Weiterhin sind die Anschlussklemmen 21 und 22 gezeigt, an die das in Fig. 5 gezeigte externe Messgerät 120 über Anschlussleitungen 130 angeschlossen ist.

Eine alternative Modulationseinrichtung ist in Fig. 4 gezeigt. Hierbei wird eine kapazitive Ankopplungseinrichtung 110 beispielsweise in Form eines Kondensators verwendet, um die elektronische Einrichtung 50 an die Sekundärwicklung 40 anzukoppeln. Die elektronische Einrichtung 50 beziehungsweise der Mikrokontroller sind derart ausgebildet, im Rhythmus der zu übertragenden Daten die Kapazität in dem Kondensator 110 zu verändern, wodurch der Sekundärstrom moduliert wird.

Angemerkt sei, dass die Trägerfrequenz des die Informationen übertragenden Datensignals deutlich oberhalb der Oberwellen des Sekundärmessstroms liegen sollte, damit das Sekundärstrommesssignal nicht durch das Datensignal verfälscht wird.

In Fig. 5 ist eine beispielhafte Messanordnung dargestellt, die beispielsweise den in Fig. 1 gezeigten induktiven Strommesswandler 10 und das bereits erwähnte externe Messgerät 120 aufweist, welches über die Anschlussleitung 130 mit dem induktiven Strommesswandler 10 verbunden ist. Die Zweidrahtanschlussleitung 130 ist mit den Anschlussklemmen 21 und 22 des induktiven Strommesswandlers 10 verbunden.

Das externe Messgerät 120 weist eine Demodulations- und Auswerteeinrichtung auf, um den über die Anschlussleitung 130 empfangenen modulierten Sekundärstrom demodulieren und auswerten zu können.

### Bezugszeichenliste

- 10: induktiver Strommesswandler
- 20: Durchstecköffnung
- 21, 22: Ausgangsanschluss, z.B. Anschlussklemme
- 30, 35: Gehäuse
- 40: Sekundärwicklung
- 41, 42: Anschluss
- 50: elektronische Einrichtung
- 51: Temperatursensor
- 52: Steuereinheit, z.B. Mikrocontroller
- 53: Spannungsmesser
- 54: Strommesser
- 55: Speicher, insbesondere für Kenndaten
- 60: erste induktive Ankopplungseinrichtung, z.B. Stromwandler
- 61: erste Wicklung
- 62: zweite Wicklung
- 64, 65: Anschluss
- 70, 72: Anschlussleiter
- 80: Energieversorgungseinrichtung
- 90: Primärwicklung
- 100: zweite induktive Ankopplungseinrichtung
- 101: erste Wicklung
- 102: zweite Wicklung
- 110: kapazitive Ankopplungseinrichtung
- 120: Messgerät
- 130: Anschlussleitung

## Patentansprüche

1. Induktiver Strommesswandler (10) zum Transformieren eines zu messenden elektrischen Primärstroms in einen elektrischen Sekundärstrom, wobei der induktive Strommesswandler (10) folgende Merkmale aufweist:
eine Sekundärwicklung (40) mit zwei Anschlüssen (41, 42),
eine elektronische Einrichtung (50), die zum Übertragen von Informationen zu einem externen Messgerät (120) ausgebildet ist, welches über eine Anschlussleitung (130) mit dem induktiven Strommesswandler (10) verbindbar ist, wobei die elektronische Einrichtung (50) einen Speicher (55) aufweist, in welchem als zu übertragende Informationen Kenndaten des induktiven Strommesswandlers (10) speicherbar sind,
eine erste mit der Sekundärwicklung (40) verbundene induktive Ankopplungseinrichtung (60),
eine Energieversorgungseinrichtung (80), die über die erste induktive Ankopplungseinrichtung (60) mit der Sekundärwicklung (40) gekoppelt und dazu ausgebildet ist, aus dem elektrischen Sekundärstrom der Sekundärwicklung (40) eine Versorgungsspannung für die elektronische Einrichtung (50) zu erzeugen,
zwei Anschlussleiter (70, 72), die jeweils mit einem der Anschlüsse (41, 42) der Sekundärwicklung (40) und jeweils mit einem Ausgangsanschluss (21, 22) verbunden sind, wobei an die Ausgangsanschlüsse (21, 22) die Anschlussleitung (130) anschließbar ist.

2. Induktiver Strommesswandler nach Anspruch 1,
**dadurch gekennzeichnet, dass**
die erste induktive Ankopplungseinrichtung (60) als Stromwandler mit einer ersten Wicklung (61) und einer zweiten Wicklung (62) ausgebildet ist, wobei einer der Anschlussleiter (70) die erste Wicklung (61) des Stromwandlers bildet und die zweite Wicklung (62) mit der Energieversorgungseinrichtung (80) verbunden ist.

3. Induktiver Strommesswandler nach Anspruch 1 oder 2, **dadurch gekennzeichnet, dass**
die elektronische Einrichtung (50) dazu ausgebildet ist, den Sekundärstrom der Sekundärwicklung (40) gezielt zu modulieren, um Informationen zum externen Messgerät (120) übertragen zu können.

4. Induktiver Strommesswandler nach Anspruch 3,
**dadurch gekennzeichnet, dass**
die elektronische Einrichtung (50) über die erste induktive Ankopplungseinrichtung (60), eine zweite induktive Ankopplungseinrichtung (100) oder eine kapazitive Ankopplungseinrichtung (110 an die Sekundärwicklung (40) angekoppelt ist, um den Sekundärstrom gezielt modulieren zu können.

5. Induktiver Strommesswandler nach einem der vorstehenden Ansprüche 1 bis 4,
**dadurch gekennzeichnet, dass**
die elektronische Einrichtung (50) eine Messeinrichtung (54) zum Messen des Sekundärstroms, eine Messeinrichtung (53) zum Messen einer an den Anschlüssen der Sekundärwicklung anliegenden Sekundärspannung und eine Einrichtung (52) zum Berechnen der elektrischen Leistung in Abhängigkeit vom Sekundärstrom und von der Sekundärspannung aufweist.

6. Induktiver Strommesswandler nach Anspruch 5,
**dadurch gekennzeichnet, dass**
die elektronische Einrichtung (50, 52) dazu ausgebildet ist, unter Ansprechen auf eine berechnete elektrische Leistung das Überschreiten einer definierten Bemessungsleistung zu erkennen und diesen Zustand mittels einer Modulation des Sekundärstroms einem externen Messgerät (120) zu signalisieren.

7. Induktiver Strommesswandler nach einem der vorstehenden Ansprüche,
**dadurch gekennzeichnet, dass**
die elektronische Einrichtung (50) einen Temperatursensor (51) aufweist und dass die elektronische Einrichtung (50) dazu ausgebildet ist, mittels einer Modulation des Sekundärstroms vom Temperatursensor (51) ermittelte Temperaturwerte zu einem externen Messgerät (120) zu übertragen.

8. Induktiver Strommesswandler nach einem der vorstehenden Ansprüche,
**dadurch gekennzeichnet, dass**
der induktive Strommesswandler (10) ein Durchsteckwandler ist.

9. Messanordnung aufweisend
einen induktiven Strommesswandler (10) nach einem der vorstehenden Ansprüche und ein externes Messgerät (120), welches über eine Anschlussleitung (130) mit dem induktiven Strommesswandler (10) verbunden ist.

10. Messanordnung nach Anspruch 9,
**dadurch gekennzeichnet, dass**
das externe Messgerät (120) zum Demodulieren und Auswerten eines vom induktiven Strommesswandler (10) modulierten Sekundärstroms ausgebildet ist.

## Claims

1. An inductive current transformer (10) for transforming a primary electric current to be measured into a secondary electric current, the inductive current transformer (10) comprising the following features:
a secondary winding (40) with two terminals (41, 42);
an electronic device (50) adapted to transfer information to an external measuring device (120) which can be connected to the inductive current transformer (10) via connection line (130), wherein the electronic device (50) comprises a memory (55) which is able to store characteristic data of the inductive current transformer (10) as an information to be transferred;
a first inductive coupling device (60) connected to the secondary winding (40);
a power supply device (80) which is coupled to the secondary winding (40) via the first inductive coupling device (60) and is adapted to generate a supply voltage for the electronic device (50) from the secondary electric current of the secondary winding (40);
two connecting conductors (70, 72), each one connected to a respective one of the terminals (41, 42) of the secondary winding (40) and to a respective one of the output terminals (21, 22), wherein the connection line (130) is connectable to the output terminals (21, 22).

2. The inductive current transformer according to claim 1, **characterised in that** the first inductive coupling device (60) is implemented as a current transformer having a first winding (61) and a second winding (62), wherein one of the connecting conductors (70) forms the first winding (61) of the current transformer and the second winding (62) is connected to the power supply device (80).

3. The inductive current transformer according to claim 1 or 2, **characterised in that** the electronic device (50) is configured to selectively modulate the secondary current of the secondary winding (40) in order to be able to transfer information to the external measuring device (120).

4. The inductive current transformer according to claim 3, **characterised in that** the electronic device (50) is coupled to the secondary winding (40) via the first inductive coupling device (60), via a second inductive coupling device (100), or via a capacitive coupling device (110) in order to be able to selectively modulate the secondary current.

5. The inductive current transformer according to any one of the preceding claims 1 to 4, **characterised in that**
the electronic device (50) comprises a measuring device (54) for measuring the secondary current, a measuring device (53) for measuring a secondary voltage applied to the terminals of the secondary winding, and a device (52) for calculating the electrical power as a function of the secondary current and of the secondary voltage.

6. The inductive current transformer according to claim 5, **characterised in that** the electronic device (50, 52) is adapted to detect, in response to a calculated electrical power, an exceeding of a predefined rated power and to signal this condition to an external measuring device (120) through a modulation of the secondary current.

7. The inductive current transformer according to any one of the preceding claims, **characterised in that**
the electronic device (50) comprises a temperature sensor (51); and that
the electronic device (50) is adapted to transfer temperature values determined by said temperature sensor (51) to an external measuring device (120) through a modulation of the secondary current.

8. The inductive current transformer according to any one of the preceding claims, **characterised in that**
the inductive current transformer (10) is a ring-type transformer.

9. A measuring arrangement, comprising
an inductive current transformer (10) according to any one of the preceding claims, and an external measuring device (120) that is connected to the inductive current transformer (10) via a connection line (130).

10. The measuring arrangement according to claim 9, **characterised in that** the external measuring device (120) is adapted for demodulating and evaluating a secondary current modulated by the inductive current transformer (10).

## Revendications

1. Transformateur de mesure de courant inductif (10) pour transformer un courant primaire électrique à mesurer en un courant secondaire électrique, où le transformateur de mesure de courant inductif (10) présente les caractéristiques suivantes :
un enroulement secondaire (40) avec deux bornes (41, 42),
un dispositif électronique (50), qui est réalisé pour transmettre des informations à un appareil de mesure externe (120), lequel peut être relié au transformateur de mesure de courant inductif (10) par l'intermédiaire d'une ligne de raccordement (130), où le dispositif électronique (50) présente une mémoire (55), dans laquelle des données caractéristiques du transformateur de mesure de courant inductif (10) en tant qu'informations à transmettre peuvent être stockées,
un premier dispositif de couplage inductif (60) relié à l'enroulement secondaire (40),
un dispositif d'alimentation en énergie (80), qui est couplé à l'enroulement secondaire (40) par l'intermédiaire du premier dispositif de couplage inductif (60) et réalisé pour produire à partir du courant secondaire électrique de l'enroulement secondaire (40) une tension d'alimentation pour le dispositif électronique (50),
deux conducteurs de borne (70, 72), qui sont reliés respectivement à une des bornes (41, 42) de l'enroulement secondaire (40) et respectivement à une borne de sortie (21, 22), où la ligne de raccordement (130) peut être raccordée aux bornes de sortie (21, 22).

2. Transformateur de mesure de courant inductif selon la revendication 1, **caractérisé en ce que**
le premier dispositif de couplage inductif (60) est réalisé sous la forme d'un transformateur de courant avec un premier enroulement (61) et un deuxième enroulement (62), où un des conducteurs de borne (70) forme le premier enroulement (61) du transformateur de courant et le deuxième enroulement (62) est relié au dispositif d'alimentation en énergie (80).

3. Transformateur de mesure de courant inductif selon la revendication 1 ou 2, **caractérisé en ce que**
le dispositif électronique (50) est réalisé pour moduler le courant secondaire de l'enroulement secondaire (40) de manière ciblée, afin de pouvoir transmettre des informations à l'appareil de mesure externe (120).

4. Transformateur de mesure de courant inductif selon la revendication 3, **caractérisé en ce que**
le dispositif électronique (50) est couplé à l'enroulement secondaire (40) par l'intermédiaire du premier dispositif de couplage inductif (60), d'un deuxième dispositif de couplage inductif (100) ou d'un dispositif de couplage capacitif (110), afin de pouvoir moduler le courant secondaire de manière ciblée.

5. Transformateur de mesure de courant inductif selon l'une quelconque des revendications précédentes 1 à 4, **caractérisé en ce que**
le dispositif électronique (50) présente un dispositif de mesure (54) pour mesurer le courant secondaire, un dispositif de mesure (53) pour mesurer une tension secondaire appliquée aux bornes de l'enroulement secondaire et un dispositif (52) pour calculer la puissance électrique en fonction du courant secondaire et de la tension secondaire.

6. Transformateur de mesure de courant inductif selon la revendication 5, **caractérisé en ce que**
le dispositif électronique (50, 52) est réalisé pour identifier, en réponse à une puissance électrique calculée, le dépassement d'une puissance de mesure définie et pour signaler cet état à un appareil de mesure externe (120) au moyen d'une modulation du courant secondaire.

7. Transformateur de mesure de courant inductif selon l'une quelconque des revendications précédentes, **caractérisé en ce que**
le dispositif électronique (50) présente un capteur de température (51) et
**en ce que** le dispositif électronique (50) est réalisé pour transmettre des valeurs de température déterminées par le capteur de température (51) à un appareil de mesure externe (120) au moyen d'une modulation du courant secondaire.

8. Transformateur de mesure de courant inductif selon l'une quelconque des revendications précédentes,
le transformateur de mesure de courant inductif (10) étant **caractérisé en ce qu'**il est un transformateur de passage.

9. Ensemble de mesure comprenant
un transformateur de mesure de courant inductif (10) selon l'une quelconque des revendications précédentes et un appareil de mesure externe (120), lequel est relié au transformateur de mesure de courant inductif (10) par l'intermédiaire d'une ligne de raccordement (130).

10. Ensemble de mesure selon la revendication 9, **caractérisé en ce que**
l'appareil de mesure externe (120) est réalisé pour démoduler et évaluer un courant secondaire modulé par le transformateur de mesure de courant inductif (10).
